# EUROPÄISCHE PATENTSCHRIFT

(11) **EP 1 594 021 B1**
(45) Veröffentlichungstag und Bekanntmachung des Hinweises auf die Patenterteilung: **20.10.2010**
(21) Anmeldenummer: 04010697.3
(22) Anmeldetag: 05.05.2004
(51) Int. Cl.: G05B 9/03, H01H 47/00, G01R 31/327

(54) **Schaltungsanordnung sowie Verfahren zum Testen von Relaisschaltkontakten einer digitalen Ausgangsschaltung**
Circuit device and method for testing relay switching contacts of a digital output circuit
Dispositif de circuit et procédé de test de contacts de commutation d'un circuit numérique de sortie

(43) Veröffentlichungstag der Anmeldung: 09.11.2005
(73) Patentinhaber: SIEMENS AKTIENGESELLSCHAFT, 80333 München (DE)
(72) Erfinder: Briemle, Thomas, 90571 Behringersdorf (DE); Maier, Mario, 92266 Ensdorf (DE); Mark, Reinhard, 91217 Hersbruck (DE); Schütz, Hartmut, 91336 Heroldsbach (DE); Wahrbichler, Joachim, 8043 Graz (AT)

(56) Entgegenhaltungen:
- EP-A- 0 192 027
- EP-A- 0 360 376
- EP-A- 0 458 300
- EP-A- 0 589 797
- EP-A- 0 665 479
- EP-A- 0 715 990
- US-A- 6 056 384

## Beschreibung

Die Erfindung betrifft eine Schaltungsanordnung für eine digitale Ausgangsschaltung, mit einem ersten und einem zweiten Schaltkontakt jeweils eines Relais, einer Steuerungseinheit zur Ansteuerung einer solchen Schaltungsanordnung, ein System aus einer solchen Schaltungsanordnung und einer solchen Steuerungseinheit, eine digitale Ausgangsschaltung mit einer solchen Schaltungsanordnung sowie ein Verfahren zum Testen von einem ersten und einem zweiten Schaltkontakt jeweils eines Relais einer solchen Schaltungsanordnung.

Bei fehlersicheren Ausgängen von digitalen Ausgangsschaltungen der industriellen Automatisierungstechnik ist es aus sicherheitstechnischen Gründen erforderlich, diese Ausgänge vor dem eigentlichen Einschalten einem Ein- und Ausschalttest zu unterziehen. Bei Ausgängen, welche nur eine der Potential-Schienen schalten (z.B. das positive Potential), führt dies bei einer Last zu einem kurzzeitigen Ein-Impuls (so genannter Helltest). Die Dauer des Helltests ist auf maximal 1 ms zu begrenzen, da ansonsten an den Ausgang angeschlossene Relais einschalten könnten. Bei fehlersicheren Ausgängen mit Relais als Schalter ist dieser Helltest nicht möglich, da hier aufgrund der längeren Schaltzeiten die maximale Helltestzeit von 1 ms überschritten würde. Allgemein bekannt ist es, bei fehlersicheren Ausgängen mit Relais als Schalter die sicherheitstechnische Funktion durch die Verwendung von mindestens drei Relais in Reihe oder die Verwendung von so genannten Sicherheitsrelais zu erreichen. Im Folgenden wird der Begriff "sicherheitsgerichtet" entsprechend DIN V VDE 0801/01.90, "Grundsätze für Rechner in Systemen mit Sicherheitsaufgaben", Abschnitt 2.3 verwendet. Dort wird der Begriff "sicherheitsgerichtet" definiert als "Fähigkeit eines Systems, beim Auftreten eines Ausfalls im sicherem Zustand zu bleiben oder unmittelbar in einen anderen sicheren Zustand überzugehen".

Aus der US 6056384 ist eine Steuereinheit zur Ansteuerung einer Schaltungsanordnung bekannt. Aus der EP 665 479 ist eine digitale Schaltungsanordnung bekannt, bei der eine Kontrolleinheit ein Fehlersignal ausgibt, wenn die über einer Anordnung von Schaltern gemessene Spannung oder Stromstärke nicht dem Erwartungswert entspricht.

Der Erfindung liegt die Aufgabe zugrunde, das Testen von Relais-Schaltkontakten von digitalen Ausgangsschaltungen zu erlauben, ohne einen Helltest am Ausgang zu verursachen.

Diese Aufgabe wird gelöst durch eine Schaltungsanordnung nach dem Anspruch 1 und ein Verfahren nach dem Anspruch 12. Die Schaltungsanordnung für eine digitale Ausgangsschaltung ist mit einem ersten und einem zweiten Schaltkontakt jeweils eines Relais ausgerüstet, wobei der erste Schaltkontakt zwischen einem Versorgungspotential und einem Verbindungspunkt zum zweiten Schaltkontakt und der zweite Schaltkontakt zwischen dem Verbindungspunkt und einem Ausgangspunkt zum Anschluss einer Last angeordnet ist, wobei der Verbindungspunkt über eine erste Schaltung mit dem Versorgungspotential verbunden ist, wobei die erste Schaltung eine Serienschaltung aus mindestens einem ersten Schaltelement und mindestens einem ersten Widerstandselement aufweist, wobei der Ausgangspunkt mittels einer zweiten Schaltung mit einem Bezugspotential verbunden ist, wobei die zweite Schaltung eine Serienschaltung aus mindestens einem zweiten Schaltelement und mindestens einem zweiten Widerstandselement aufweist, und wobei Mittel zur Bestimmung der Potentiale des Verbindungspunkts und des Ausgangspunkts vorgesehen sind.

Bei dem Verfahren zum Testen von einem ersten und einem zweiten Schaltkontakt jeweils eines Relais einer Schaltungsanordnung nach einem der Ansprüche 1 bis 7 werden die ersten und zweiten Schaltmittel und Schaltkontakte mit einer Steuerungseinheit nach einem der Ansprüche 8 bis 10 derart angesteuert und Potentiale mit einer Steuerungseinheit nach Anspruch 9 oder 10 derart ausgewertet, dass Fehler der Schaltkontakte feststellbar sind.

Die erfindungsgemäße Schaltungsanordnung erlaubt einen Test des ersten und des zweiten Relais-Schaltkontakts, ohne einen Helltest am Ausgangspunkt zu verursachen. Zudem bietet die vorgeschlagene Lösung im Vergleich zu den oben genannten bekannten Lösungen Platzersparnis und führt damit zu einer Kostenreduktion. Die erfindungsgemäße Schaltungsanordnung kann somit in kleineren Gehäusen realisiert werden.

Gemäß einer vorteilhaften Ausgestaltung der Erfindung sind die Mittel zur Bestimmung des Potentials als Spannungsteiler ausgebildet. Spannungsteiler, z.B. als in Serie geschaltete Widerstände realisiert, sind eine günstige Möglichkeit zur Spannungserfassung, welche gleichzeitig den Vorteil bietet, dass die am Spannungsteiler abgreifbare Spannung einen für eine Auswertung erforderlichen (Maximal-)Wert erhält.

Gemäß einer weiteren vorteilhaften Ausgestaltung der Erfindung sind die Schaltelemente der Schaltungsanordnung als Halbleiterschaltelemente, insbesondere als Transistoren, ausgebildet. Halbleiterschaltelemente lassen sich besonders einfach und schnell ansteuern.

Wird der Widerstandswert der ersten Widerstandselemente gemäß einer weiteren vorteilhaften Ausgestaltung der Erfindung derart gewählt, dass ein über die erste Schaltung fließender, vom Versorgungspotential getriebener Strom so begrenzt wird, dass eine festlegbare Stromstärke nicht überschritten wird, so kann erreicht werden, dass ein auf eine entsprechende geringe Stromstärke eingestellter Teststrom über den zweiten Schaltkontakt und somit über eine gegebenenfalls angeschlossene Last fließt, wobei dieser Teststrom kein Anziehen eines Relais der Last verursachen würde.

Entsprechend kann ein während eines Testbetriebs unerwünscht hohes Potential am Ausgangspunkt gemäß einer weiteren vorteilhaften Ausgestaltung der Erfindung dadurch verhindert werden, dass die Widerstandswerte der ersten und zweiten Widerstandselemente derart gewählt sind, dass bei eingeschalteten ersten und zweiten Schaltelementen, geöffnetem ersten Schaltkontakt und geschlossenem zweiten Schaltkontakt das Potential am Ausgangspunkt einen festlegbaren Wert nicht überschreitet.

Um die Schaltungsanordnung für kapazitive Lasten zu optimieren, wird vorgeschlagen, dass die zweite Schaltung als aktive Entladeschaltung für kapazitive Lasten ausgebildet ist, wobei das zweite Widerstandselement als niederohmiger Entladewiderstand ausgebildet ist.

Vorteilhafterweise wird die Schaltungsanordnung für eine sicherheitsgerichtete digitale Ausgangsschaltung vorgesehen, da sich die Funktion des ersten und des zweiten Schaltkontakts sicher testen lässt.

Es wird vorgeschlagen, eine insbesondere als Mikrocontroller ausgebildete Steuerungseinheit zur Ansteuerung der Schaltungsanordnung einzusetzen, wobei die Steuerungseinheit Mittel zur Ansteuerung der Schaltmittel und der Schaltkontakte sowie Auswertemittel zur Auswertung der von den Mitteln zur Bestimmung des Potentials des Verbindungspunkts und des Ausgangspunkts bestimmten Potentiale aufweist.

Das erfindungsgemäße Verfahren ermöglicht ein schnelles, zuverlässiges und energiesparendes Testen von einem ersten und einem zweiten Schaltkontakt jeweils eines Relais einer erfindungsgemäßen Schaltungsanordnung. Es wird vorgeschlagen, die Schaltfähigkeit der Relaiskontakte im Hochlauf der Ausgangsschaltung zu überprüfen, wobei kein Helltest stattfindet. Gemäß einer vorteilhaften Ausgestaltung des erfindungsgemäßen Verfahrens wird zudem vorgeschlagen, diesen so genannten virtuellen Helltest bei Vorliegen eines Nutzsignals = 0 zyklisch, insbesondere einmal pro Stunde, durchzuführen.

Vorteilhafterweise wird vor Ausgabe des Nutzsignals, d.h. bei einer Änderung des Nutzsignals von 0 auf 1, ein solches Verfahren durchgeführt, um sicherzugehen, dass das daraufhin ausgegebene Nutzsignal fehlersicher ausgegeben wird. Um einen solchen dynamischen Schaltungstest nicht bei jeder Änderung des Nutzsignals von 0 auf 1 durchführen zu müssen, wird gemäß einer weiteren vorteilhaften Ausgestaltung des erfindungsgemäßen Verfahrens dieser dynamische Schaltungstest nur dann durchgeführt, wenn seit der Durchführung des letzten zyklischen virtuellen Helltests eine vorbestimmbare Zeit verstrichen ist.

Nachfolgend wird die Erfindung anhand der in den Figuren dargestellten Ausführungsbeispiele näher beschrieben und erläutert.

### Es zeigen:

- FIG 1: eine schematische Darstellung eines Ausführungsbeispiels der erfindungsgemäßen Schaltungsanordnung und
- FIG 2: ein Ausführungsbeispiel der erfindungsgemäßen Schaltungsanordnung.

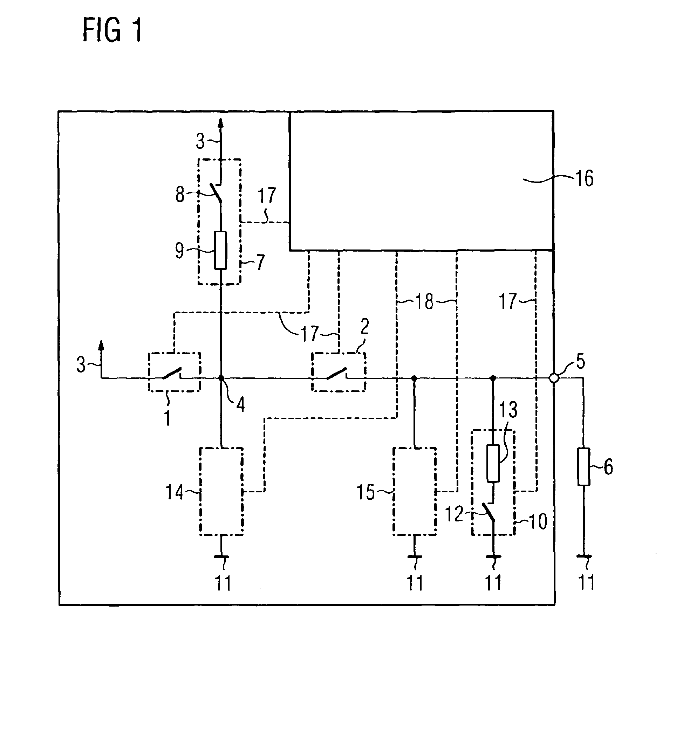

Figur 1 zeigt in schematischer Darstellung eine Schaltungsanordnung für eine digitale Ausgangsschaltung. Eine Serienschaltung aus einem ersten und einem zweiten Schaltkontakt 1, 2 von hier nicht näher dargestellten Relais ist zwischen ein Versorgungspotential 3 und einen Ausgangspunkt 5 zum Anschluss einer Last 6, z. B. einer Ausgangsklemme, angeordnet. Die Last 6 ist zwischen dem Ausgangspunkt 5 und einem Bezugspotential 11 angeschlossen. Zwischen das Versorgungspotential 3 und den Verbindungspunkt 4 zwischen den Schaltkontakten 1, 2 ist eine erste Schaltung 7 geschaltet, welche eine Serienschaltung aus einem Widerstandselement 9 und einem Schaltelement 8 enthält. Zwischen den Ausgangspunkt 5 und das Bezugspotential 11 ist eine zweite Schaltung 10 geschaltet, welche eine Serienschaltung aus einem Widerstandselement 13 und einem Schaltelement 12 enthält. Zudem weist die Schaltungsanordnung Mittel 14, 15 zur Bestimmung des Potentials des Verbindungspunkts 4 und des Ausgangspunkts 5 bezüglich des Bezugspotentials 11 auf. Eine Steuerungseinheit, welche Teil der Schaltungsanordnung, Teil der digitalen Ausgangsschaltung oder extern angeordnet sein kann, dient zur Ansteuerung der Schaltungsanordnung, wobei die Steuerungseinheit Mittel 16, 17 zur Ansteuerung der Schaltelemente 8, 12 und der Schaltkontakte 1, 2 aufweist. Zudem weist die Steuerungseinheit Mittel 16 zur Auswertung der von den Mitteln 14, 15 zur Bestimmung des Potentials des Verbindungspunkts 4 und des Ausgangspunkts 5 bestimmten Potentiale auf.

Anhand des Ausführungsbeispiels gemäß Figur 1 soll im Folgenden ein Verfahren zum Testen des ersten und des zweiten Schaltkontakts beschrieben werden. Während des Betriebs ist es normalerweise nicht möglich, die Schaltfähigkeit eines Relaisausgangs zu testen, wegen der Trägheit der Relaisschaltkontakte und dem Auftreten von Dunkelzeiten. Daher wird die Schaltfähigkeit der Relaiskontakte zunächst im Hochlauf überprüft. Es findet dabei kein Helltest statt. Die im Folgenden beschriebene Testsequenz wird abgearbeitet.

Im Schritt 1 werden sowohl die Schaltelemente 8, 12 als auch die Schaltkontakte 1, 2 derart angesteuert, dass sie geöffnet sind. Über die Mittel 14, 15 wird nun das Potential des Verbindungspunkts 4 und des Ausgangspunkts 5 bestimmt. Die bestimmten Potentiale werden im Folgenden als rückgelesene Signale S1 (Verbindungspunkt 4) bzw. S2 (Ausgangspunkt 5) bezeichnet, welche jeweils den Wert logisch 0 oder logisch 1 annehmen können. Kein Fehler der Schaltkontakte 1, 2 liegt vor, wenn im Schritt 1 S1 = S2 = 0 ist. Ist S1 = 1 und S2 = 0, deutet das darauf hin, dass der erste Schaltkontakt 1 durchlegiert ist, und somit das Versorgungspotential 3 über den durchlegierten Schaltkontakt 1 am Verbindungspunkt 4 anliegt. Als Maßnahme zur Fehlerbehebung würde in diesem Fall die Baugruppe getauscht werden. Ist S1 = 0 und S2 = 1, deutet das auf einen externen P-Schluss (d.h., dass das Versorgungspotential am Ausgangspunkt 5 von extern anliegt) und auf einen Defekt des ersten Mittels 14 zur Bestimmung des Potentials des Verbindungspunkts 4 hin. Auch in diesem Fall würde die Baugruppe getauscht werden, um den Fehler zu beheben. Sind beide rückgelesenen Signale S1 und S2 = 1, liegt entweder ein externer P-Schluss vor oder die Schaltkontakte 1 und 2 sind durchlegiert. Durch Prüfen der Verdrahtung kann hier die genaue Fehlerursache festgestellt werden und gegebenenfalls die Baugruppe getauscht werden.

Im Schritt 2 des Hochlauftests werden beide Schaltkontakte 1 und 2 so angesteuert, dass sie ausgeschaltet sind und die Schaltelemente so angesteuert, dass sie eingeschaltet sind, so dass ein Teststrom aufgeschaltet wird. Kein Fehler liegt vor, wenn S1 = 1 und S2 = 0 ist. Sind beide Signale S1 und S2 = 0, so ist die Testschaltung defekt und die Baugruppe muss getauscht werden. Die Fälle S1 = 0, S2 = 1 sowie S1 = S2 = 1 entsprechen den gleichen Fällen beim Schritt 1.

Im Schritt 3 wird der zweite Schaltkontakt eingeschaltet. Die Schaltelemente bleiben unverändert zum Schritt 2, d.h. eingeschaltet. In diesem Fall liegt kein Fehler vor, wenn S1 = S2 = 0 ist. Für den Fall, dass S1 = 1 und S2 = 0 ist, kann daraus geschlossen werden, dass der erste Schaltkontakt 1 durchlegiert ist und die Baugruppe zu tauschen ist. Die Fälle S1 = 0, S2 = 1 sowie S1 = S2 = 1 verhalten sich wie in den Schritten 1 und 2 beschrieben.

Im Schritt 4 wird der zweite Schaltkontakt wieder ausgeschaltet, wobei die Schaltelemente eingeschaltet bleiben. Der Zustand im Schritt 4 entspricht dem im Schritt 3 mit dem Unterschied, dass S1 = S2 = 0 darauf hindeutet, dass der zweite Schaltkontakt 2 durchlegiert ist und die Baugruppe zu tauschen ist.

Im Schritt 5 wird der Teststrom abgeschaltet, indem die Schaltelemente ausgeschaltet werden, wobei beide Schaltkontakte 1 und 2 ebenfalls ausgeschaltet bleiben. Der Zustand im Schritt 5 entspricht somit dem Zustand in Schritt 1, ebenso die Auswertung der rückgelesenen Signale S1 und S2.

Im Schritt 6 wird der Schaltkontakt 1 eingeschaltet, wobei die Schaltelemente ausgeschaltet bleiben. In diesem Fall liegt kein Fehler vor, wenn S1 = 1 und S2 = 0 ist. Sind beide Signale S1 und S2 = 0, deutet das auf einen Defekt des ersten Schaltkontakts 1 hin, so dass in diesem Fall die Baugruppe getauscht werden sollte. Die Fälle S1 = 0, S2 = 1 sowie S1 = S2 = 1 entsprechen den Fällen bei den Schritten 1 bis 5. Im letzten Schritt 7 wird der erste Schaltkontakt 1 wieder ausgeschaltet, so dass sich der gleiche Zustand wie beim Schritt 1 und beim Schritt 5 ergibt, mit dem gleichen potentiellen Fehlerbild wie bei diesen Schritten.

Der soeben beschriebene Hochlauftest kann als so genannter virtueller Helltest zyklisch bei Nutzsignal = 0 wiederholt werden, insbesondere einmal pro Stunde.

Bei erhöhten Sicherheitsanforderungen an die Ausgangsschaltung können die Schritte 2 bis 5 des Hochlauftests bzw. des virtuellen Helltests als so genannter dynamischer Schaltungstest bei einem Übergang des Nutzsignals von 0 auf 1 durchgeführt werden, bevor das Nutzsignal ausgegeben wird. Ein solcher dynamischer Schaltungstest wird vorteilhafterweise jedoch nur dann durchgeführt, wenn innerhalb der letzten Stunde kein virtueller Helltest durchgeführt wurde bzw. kein anderer 0 auf 1 Übergang stattgefunden hat. Durch den dynamischen Schaltungstest wird der zweite Schaltkontakt 2 vor dem Einschalten geprüft, so dass ein Aufschalten der Versorgungsspannung im Fehlerfall verhindert wird. Durch diesen Test wird jedoch das Aufschalten eines Prozesswerts von 1 um ca. 10 ms verzögert.

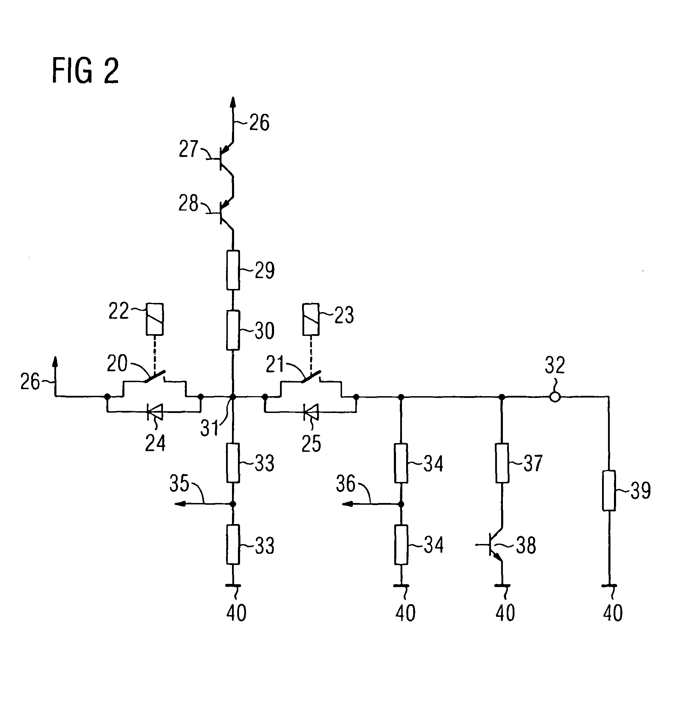

Figur 2 zeigt ein Ausführungsbeispiel der erfindungsgemäßen Schaltungsanordnung. Die Schaltungsanordnung gemäß Figur 2 weist einen ersten Schaltkontakt 20 und einen zweiten Schaltkontakt 21 jeweils eines Relais auf. Die Relaisansteuerung der Schaltkontakte 20, 21 wird mit den Bezugszeichen 22 bzw. 23 bezeichnet. Parallel zu den Schaltkontakten 20, 21 ist jeweils eine Freilaufdiode 24, 25 geschaltet, z. B. in Form einer parasitären Diode eines parallel geschalteten Transistors (Funkenlöschung). Der erste Schaltkontakt 20 ist zwischen ein Versorgungspotential 26, in diesem Fall eine positive Spannung von 24 V, und einem Verbindungspunkt 31 zum zweiten Schaltkontakt 21 geschaltet. Der zweite Schaltkontakt 21 ist zwischen dem Verbindungspunkt 31 und einem Ausgangspunkt 32 zum Anschluss der Last 39 angeordnet. Die Last ist zwischen dem Ausgangspunkt 32 und dem Bezugspotential 40, der Masse, anschließbar. Der Verbindungspunkt 31 ist über eine erste Schaltung mit dem versorgungspotential 26 verbunden, wobei die erste Schaltung eine Serienschaltung aus zwei ersten Schaltelementen 27, 28, in diesem Fall als Transistoren ausgeführt, und zwei in Serie geschalteten Widerständen 29, 30 ist. Der Ausgangspunkt 32 ist mittels einer zweiten Schaltung mit dem Bezugspotential 40 verbunden, wobei die zweite Schaltung eine Serienschaltung aus einem zweiten Schaltelement 38, welches in diesem Fall als Transistor ausgeführt ist, und einem Widerstand 37 ausgebildet ist. Die Mittel zur Bestimmung des Potentials des Verbindungspunkts 31 bzw. des Ausgangspunkts 32 sind in diesem Fall als aus jeweils zwei in Serie geschalteten Widerständen gebildeten Spannungsteilern 33 bzw. 34 ausgebildet, an denen zu Auswertungszwecken durch eine oder mehrere hier nicht dargestellte Auswertungseinheiten die Spannungen 35 bzw. 36 abgreifbar sind.

Die Ansteuerung der Schaltungsanordnung und die Auswertung der Signale erfolgt im Ausführungsbeispiel gemäß Figur 2 durch zwei Auswerteeinheiten, welche z.B. durch einen Mikrocontroller realisiert sind.

Der ersten Auswerteeinheit sind zugeordnet:
- Ansteuerung des ersten Schaltelements 27:
   Teststromaufschaltung
- Ansteuerung des ersten Schaltkontakts 20:
   erstes Ausgangsrelais
- Rücklesesignal:
   Rücklesen des Relaiskontakts vom zweiten Ausgangsrelais

Der zweiten Auswerteeinheit sind zugeordnet:
- Ansteuerung des zweiten Schaltelements 38:
   Teststromaufschaltung
- Ansteuerung des zweiten Schaltkontakts 21:
   zweites Ausgangsrelais
- Ansteuerung des Schaltelements 37:
   Entladeschaltung
- Rücklesesignal 35:
   Rücklesen des Relaiskontakts vom ersten Ausgangsrelais

Über die ersten Schaltelemente 27, 28 sowie über die Widerstände 29, 30 wird der Teststrom zum Test des zweiten Relaiskontakts eingespeist. Die Widerstände 33 und 34 bilden Spannungsteiler zum Rücklesen der Schaltsignale. Die zweite Schaltung aus Widerstand 37 und Schaltelement 38 bildet eine Entladeschaltung für kapazitive Lasten, über welche auch der Teststrom bei hochohmigen Lasten abfließt.

Typische Werte für die Widerstände einer Schaltungsanordnung gemäß Figur 2 sind: Widerstand 29: 2,43 kΩ; Widerstand 30: 2,43 kΩ; Widerstände 33: 39,2 kΩ bzw. 12 kΩ; Widerstände 34: 39,2 kΩ bzw. 12 kΩ und Widerstand 37: 950 Ω.

Eine solchermaßen ausgeführte Schaltung erlaubt einen Test des zweiten Relaiskontakts 21, ohne einen Helltest am Ausgang 32 zu verursachen. Dabei fließt ein geringer Teststrom von ca. 5 mA über den zweiten Relaiskontakt 21. Durch die aktive Entladeschaltung (Widerstand 37 und Schaltelement 38) werden die Einflüsse bei kapazitiven Lasten unterdrückt und daher kann der Test relativ schnell durchgeführt werden. Durch den niederohmigen Entladewiderstand 37 von 950 Ω wird am Ausgang ein Spannungsimpuls von maximal 4 V sichtbar, bei einer Versorgungsspannung von 24 V.

Zusammengefasst betrifft die Erfindung somit eine Schaltungsanordnung für eine digitale Ausgangsschaltung, mit einem ersten und einem zweiten Schaltkontakt 1, 2 jeweils eines Relais, wobei der erste Schaltkontakt 1 zwischen einem Versorgungspotential 3 und einem Verbindungspunkt 4 zum zweiten Schaltkontakt 2 und der zweite Schaltkontakt 2 zwischen dem Verbindungspunkt 4 und einem Ausgangspunkt 5 zum Anschluss einer Last 6 angeordnet ist. Um das Testen der Relais-Schaltkontakte 1, 2 zu erlauben, ohne einen Helltest am Ausgang zu verursachen, wird vorgeschlagen, dass der Verbindungspunkt 4 über eine erste Schaltung 7 mit dem Versorgungspotential 3 verbunden ist, wobei die erste Schaltung 7 eine Serienschaltung aus mindestens einem ersten Schaltelement 8 und mindestens einem ersten Widerstandselement 9 aufweist, wobei der Ausgangspunkt 5 mittels einer zweiten Schaltung 10 mit einem Bezugspotential 11 verbunden ist, wobei die zweite Schaltung 10 eine Serienschaltung aus mindestens einem zweiten Schaltelement 12 und mindestens einem zweiten Widerstandselement 13 aufweist, wobei Mittel 14, 15 zur Bestimmung der Potentiale des Verbindungspunkts 4 und des Ausgangspunkts 5 vorgesehen sind. Die Erfindung betrifft zudem ein Verfahren zum Testen von einem ersten und einem zweiten Schaltkontakt 1, 2 jeweils eines Relais einer solchen Schaltungsanordnung.

## Patentansprüche

1. Schaltungsanordnung für eine digitale Ausgangsschaltung, mit einem ersten und einem zweiten Schaltkontakt (1, 2) jeweils eines Relais, wobei
der erste Schaltkontakt (1) zwischen einem Versorgungspotential (3) und einem Verbindungspunkt (4) zum zweiten Schaltkontakt (2) und der zweite Schaltkontakt (2) zwischen dem Verbindungspunkt (4) und einem Ausgangspunkt (5) zum Anschluss einer Last (6) angeordnet ist, der Verbindungspunkt (4) über eine erste Schaltung (7) mit dem Versorgungspotential (3) verbunden ist, und der Ausgangspunkt (5) mittels einer zweiten Schaltung (10) mit einem Bezugspotential (11) verbunden ist, und mit Mitteln (14, 15) zur Bestimmung der Potentiale des Verbindungspunkts (4) und des Ausgangspunkts (5) **dadurch gekennzeichnet, dass** die erste Schaltung (7) eine Serienschaltung aus mindestens einem ersten Schaltelement (8) und mindestens einem ersten Widerstandselement (9) aufweist und die zweite Schaltung (10) eine Serienschaltung aus mindestens einem zweiten Schaltelement (12) und mindestens einem zweiten Widerstandselement (13) aufweist.

2. Schaltungsanordnung nach Anspruch 1,
**dadurch gekennzeichnet,**
**dass** die Mittel (14, 15) zur Bestimmung des Potentials einen Spannungsteiler aufweisen.

3. Schaltungsanordnung nach Anspruch 1 oder 2,
**dadurch gekennzeichnet,**
**dass** die Schaltelemente (8, 12) Halbleiterschaltelemente sind.

4. Schaltungsanordnung nach einem der vorhergehenden Ansprüche,
**dadurch gekennzeichnet,**
**dass** der Widerstandswert der ersten Widerstandselemente (9) derart ist, dass ein über die erste Schaltung (7) fließender, vom Versorgungspotential (3) getriebener Strom so begrenzt wird, dass eine festlegbare Stromstärke nicht überschritten wird.

5. Schaltungsanordnung nach einem der vorhergehenden Ansprüche,
**dadurch gekennzeichnet,**
**dass** die Widerstandswerte der ersten und zweiten Widerstandselemente (9, 13) derart sind, dass bei eingeschalteten ersten und zweiten Schaltelementen (8, 12), geöffnetem ersten Schaltkontakt (1) und geschlossenem zweiten Schaltkontakt (2) das Potential am Ausgangspunkt (5) einen festlegbaren Wert nicht überschreitet.

6. Schaltungsanordnung nach einem der vorhergehenden Ansprüche,
**dadurch gekennzeichnet,**
**dass** die zweite Schaltung (10) eine aktive Entladeschaltung für kapazitive Lasten ist, wobei das zweite Widerstandselement (13) als niederohmiger Entladewiderstand ausgebildet ist.

7. Schaltungsanordnung nach einem der vorhergehenden Ansprüche,
**dadurch gekennzeichnet,**
**dass** die digitale Ausgangsschaltung eine sicherheitsgerichtete digitale Ausgangsschaltung ist.

8. System aus mindestens einer Schaltungsanordnung nach einem der Ansprüche 1 bis 7 und einer Steuerungseinheit, wobei die Steuerungseinheit Mittel (16, 17) zur Ansteuerung der Schaltelemente (8, 12) und der Schaltkontakte (1, 2) aufweist.

9. System nach Anspruch 8, wobei die Steuerungseinheit Auswertemittel (16) zur Auswertung der von den Mitteln (14, 15) zur Bestimmung der Potentiale des Verbindungspunkts (4) und des Ausgangspunkts (5) bestimmten Potentiale aufweist.

10. System nach Anspruch 8 oder 9, wobei die Steuerungseinheit ein Mikrocontroller ist.

11. Digitale Ausgangsschaltung mit einer Schaltungsanordnung nach einem der Ansprüche 1 bis 7.

12. Verfahren zum Testen des ersten und des zweiten Schaltkontakts (1, 2) jeweils eines Relais einer Schaltungsanordnung nach einem der Ansprüche 1 bis 7, wobei die ersten und zweiten Schaltelemente (8, 12) und die Schaltkontakte (1, 2) mit einer Steuerungseinheit nach einem der Ansprüche 8 bis 10 derart angesteuert werden und mit einer Steuerungseinheit nach Anspruch 9 oder 10 derart ausgewertet werden, dass Fehler der Schaltkontakte (1, 2) feststellbar sind.

13. Verfahren nach Anspruch 12,
**dadurch gekennzeichnet,**
**dass** es beim Hochlaufen der Ausgangsschaltung durchgeführt wird.

14. Verfahren nach Anspruch 12 oder 13,
**dadurch gekennzeichnet,**
**dass** es zyklisch bei Vorliegen eines Nutzsignals gleich Null durchgeführt wird.

15. Verfahren nach einem der Ansprüche 12 bis 14,
**dadurch gekennzeichnet,**
**dass** es bei einer Änderung des Nutzsignals von Null auf Eins durchgeführt wird.

16. Verfahren nach Anspruch 15,
**dadurch gekennzeichnet,**
**dass** es nur dann wieder durchgeführt wird, wenn seit der Durchführung eines Verfahrens nach Anspruch 15 eine vorbestimmbare Zeit verstrichen ist.

## Claims

1. Circuit arrangement for a digital output circuit, having a first switching contact (1) and a second switching contact (2) of a respective relay, the first switching contact (1) being arranged between a supply potential (3) and a connection point (4) to the second switching contact (2) and the second switching contact (2) being arranged between the connection point (4) and an output point (5) for connecting a load (6), the connection point (4) being connected to the supply potential (3) via a first circuit (7), and the output point (5) being connected to a reference potential (11) by means of a second circuit (10), and having means (14, 15) for determining the potentials of the connection point (4) and of the output point (5), **characterized in that** the first circuit (7) has a series circuit comprising at least one first switching element (8) and at least one first resistance element (9), and the second circuit (10) has a series circuit comprising at least one second switching element (12) and at least one second resistance element (13).

2. Circuit arrangement according to Claim 1,
**characterized in that**
the means (14, 15) for determining the potential have a voltage divider.

3. Circuit arrangement according to Claim 1 or 2, **characterized in that**
the switching elements (8, 12) are semiconductor switching elements.

4. Circuit arrangement according to one of the preceding claims,
**characterized in that**
the resistance value of the first resistance elements (9) is such that a current flowing via the first circuit (7) and driven from the supply potential (3) is limited in such a manner that a determinable current intensity is not exceeded.

5. Circuit arrangement according to one of the preceding claims,
**characterized in that**
the resistance values of the first and second resistance elements (9, 13) are such that the potential at the output point (5) does not exceed a determinable value when the first and second switching elements (8, 12) are switched on, the first switching contact (1) is open and the second switching contact (2) is closed.

6. Circuit arrangement according to one of the preceding claims,
**characterized in that**
the second circuit (10) is an active discharge circuit for capacitive loads, the second resistance element (13) being in the form of a low-value discharge resistor.

7. Circuit arrangement according to one of the preceding claims,
**characterized in that**
the digital output circuit is a safety-oriented digital output circuit.

8. System comprising at least one circuit arrangement according to one of Claims 1 to 7 and a control unit, the control unit having means (16, 17) for driving the switching elements (8, 12) and the switching contacts (1, 2).

9. System according to Claim 8, the control unit having evaluation means (16) for evaluating the potentials determined by the means (14, 15) for determining the potentials of the connection point (4) and of the output point (5).

10. System according to Claim 8 or 9, the control unit being a microcontroller.

11. Digital output circuit having a circuit arrangement according to one of Claims 1 to 7.

12. Method for testing the first and second switching contacts (1, 2) of a respective relay of a circuit arrangement according to one of Claims 1 to 7, the first and second switching elements (8, 12) and the switching contacts (1, 2) being driven with a control unit according to one of Claims 8 to 10 and being evaluated with a control unit according to Claim 9 or 10 in such a manner that faults in the switching contacts (1, 2) can be determined.

13. Method according to Claim 12,
**characterized in that**
the method is carried out when starting up the output circuit.

14. Method according to Claim 12 or 13,
**characterized in that**
the method is cyclically carried out when a useful signal equal to zero is present.

15. Method according to one of Claims 12 to 14,
**characterized in that**
the method is carried out when the useful signal changes from zero to one.

16. Method according to Claim 15,
**characterized in that**
the method is carried out again only when a predeterminable amount of time has elapsed since a method according to Claim 15 was carried out.

## Revendications

1. Montage pour un circuit numérique de sortie comprenant un premier et un deuxième contacts ( 1, 2 ) de commutation respectivement d'un relais, dans lequel
le premier contact ( 1 ) de commutation est monté entre un potentiel ( 3 ) d'alimentation et un point ( 4 ) de liaison avec le deuxième contact ( 2 ) de commutation et le deuxième contact ( 2 ) de commutation est monté entre le point ( 4 ) de liaison et un point ( 5 ) de sortie, pour le raccordement d'une charge ( 6 ), le point ( 4 ) de liaison étant relié par un premier circuit ( 7 ) au potentiel ( 3 ) d'alimentation et le point ( 5 ) de sortie étant relié à un potentiel ( 11 ) de référence au moyen d'un deuxième circuit ( 10 ), et comprenant les moyens ( 14, 15 ) de détermination des potentiels du point ( 4 ) de liaison et du point ( 5 ) de sortie, **caractérisé en ce que** le premier circuit ( 7 ) comporte un circuit série composé d'au moins un premier élément ( 8 ) de commutation et d'au moins un premier élément ( 9 ) de résistance et le deuxième circuit ( 10 ) comporte un circuit série composé d'au moins un deuxième élément ( 12 ) de commutation et d'au moins un deuxième élément ( 13 ) de résistance.

2. Montage suivant la revendication 1,
**caractérisé**
**en ce que** les moyens ( 14, 15 ) de détermination du potentiel comportent un diviseur de tension.

3. Montage suivant la revendication 1 ou 2,
**caractérisé**
**en ce que** les éléments ( 8, 12 ) de commutation sont des éléments de commutation à semiconducteur.

4. Montage suivant l'une des revendications précédentes,
**caractérisé**
**en ce que** la valeur de la résistance des premiers éléments ( 9 ) de résistance est choisie de façon à limiter un courant passant dans le premier circuit ( 7 ) et fourni par le potentiel ( 3 ) d'alimentation, de manière à ne pas dépasser une intensité de courant pouvant être fixée.

5. Montage suivant l'une des revendications précédentes,
**caractérisé**
**en ce que** les valeurs de résistance des premier et deuxième éléments ( 9, 13 ) de résistance sont choisies de façon à ce que, lorsque les premier et deuxième éléments ( 8, 12 ) de commutation sont fermés, le premier contact de commutation ( 1 ) est ouvert et le deuxième contact ( 2 ) de commutation est fermé, le potentiel au point ( 5 ) de sortie ne dépasse pas une valeur qui peut être fixée.

6. Montage suivant l'une des revendications précédentes,
**caractérisé**
**en ce que** le deuxième circuit ( 10 ) est un circuit actif de décharge, pour des charges capacitives, le deuxième élément ( 13 ) de résistance étant constitué sous la forme d'une résistance de décharge de petite valeur ohmique.

7. Montage suivant l'une des revendications précédentes,
**caractérisé**
**en ce que** le circuit numérique de sortie est un circuit numérique de sortie de sécurité.

8. Système composé d'au moins un montage suivant l'une des revendications 1 à 7, et d'une unité de commande, l'unité de commande ayant des moyens ( 16, 17 ) de commande des éléments ( 8, 12 ) de commutation et des contacts ( 1, 2 ) de commutation.

9. Système suivant la revendication 8, dans lequel l'unité de commande comporte des moyens ( 16 ) d'exploitation des potentiels déterminés par les moyens ( 14, 15 ) de détermination des potentiels du point ( 4 ) de liaison et du point ( 5 ) de sortie.

10. Système suivant la revendication 8 ou 9, dans lequel l'unité de commande est un microcontrôleur.

11. Circuit numérique de sortie ayant un montage suivant l'une des revendications 1 à 7.

12. Procédé de test du premier et du deuxième contacts ( 1, 2 ) de commutation de respectivement un relais d'un montage suivant l'une des revendications 1 à 7, dans lequel on commande les premier et deuxième éléments ( 8, 12 ) de commutation et les contacts ( 1, 2 ) de commutation par une unité de commande suivant l'une des revendications 8 à 10 et on les évalue par une unité de commande suivant la revendication 9 ou 10, de manière à pouvoir constater les défauts des contacts ( 1, 2 ) de commutation.

13. Procédé suivant la revendication 12,
**caractérisé**
**en ce qu'**on l'effectue alors que le circuit de sortie fonctionne.

14. Procédé suivant la revendication 12 ou 13,
**caractérisé**
**en ce qu'**on l'effectue cycliquement en présence d'un signal utile égal à zéro.

15. Procédé suivant l'une des revendications 12 à 14, **caractérisé**
**en ce qu'**on l'effectue lors d'un passage du signal utile de zéro à un.

16. Procédé suivant la revendication 15,
**caractérisé**
**en ce qu'**on ne l'effectue à nouveau que si, depuis que l'on a effectué un procédé suivant la revendication 15, il s'est écoulé une durée pouvant être déterminée à l'avance.
